# FASCICULE DE BREVET EUROPEEN

(11) **EP 3 172 769 B1**
(45) Date de publication et mention de la délivrance du brevet: **27.02.2019**
(21) Numéro de dépôt: 15741565.4
(22) Date de dépôt: 27.07.2015
(51) Int. Cl.: H01L 31/0352, H01L 31/042, H01L 31/05, H01L 31/0475, H01L 31/068, H01L 31/18

(54) **MODULE PHOTOVOLTAIQUE COMPRENANT UNE PLURALITE DE CELLULES BIFACIALES ET PROCEDE DE FABRICATION D'UN TEL MODULE**
FOTOVOLTAISCHES MODUL MIT MEHREREN ZWEISEITIGEN ZELLEN UND VERFAHREN ZUR HERSTELLUNG SOLCH EINES MODULS
PHOTOVOLTAIC MODULE COMPRISING A PLURALITY OF BIFACIAL CELLS AND METHOD FOR PRODUCING SUCH A MODULE

(30) Priorité: 25.07.2014 FR 1457200
(43) Date de publication de la demande: 31.05.2017
(73) Titulaire: Commissariat à l'Énergie Atomique et aux Énergies Alternatives, 75015 Paris (FR)
(72) Inventeur: LEFILLASTRE, Paul, 75013 Paris (FR); GERRITSEN, Eric, 38190 Bernin (FR)
(74) Mandataire: Regimbeau
(86) Numéro de dépôt international: PCT/EP2015/067118
(87) Numéro de publication internationale: WO 2016/012626

(56) Documents cités:
- EP-A1- 1 770 791
- EP-A1- 2 400 560
- EP-A2- 2 654 089
- WO-A2-2013/167564
- WO-A2-2014/071417

## Description

### DOMAINE DE L'INVENTION

La présente invention concerne un module photovoltaïque comprenant une pluralité de cellules photovoltaïques bifaciales et un procédé de fabrication d'un tel module.

### ARRIERE PLAN DE L'INVENTION

Dans un module photovoltaïque, les cellules photovoltaïques peuvent être connectées en série au moyen d'un élément électriquement conducteur, tel qu'un ruban de cuivre, qui relie la face avant d'une cellule à la face arrière de la cellule adjacente.

Dans un tel module, la face avant des différentes cellules est située d'un même côté, formant la face avant du module, et la face arrière est située du côté opposé, formant la face arrière du module.

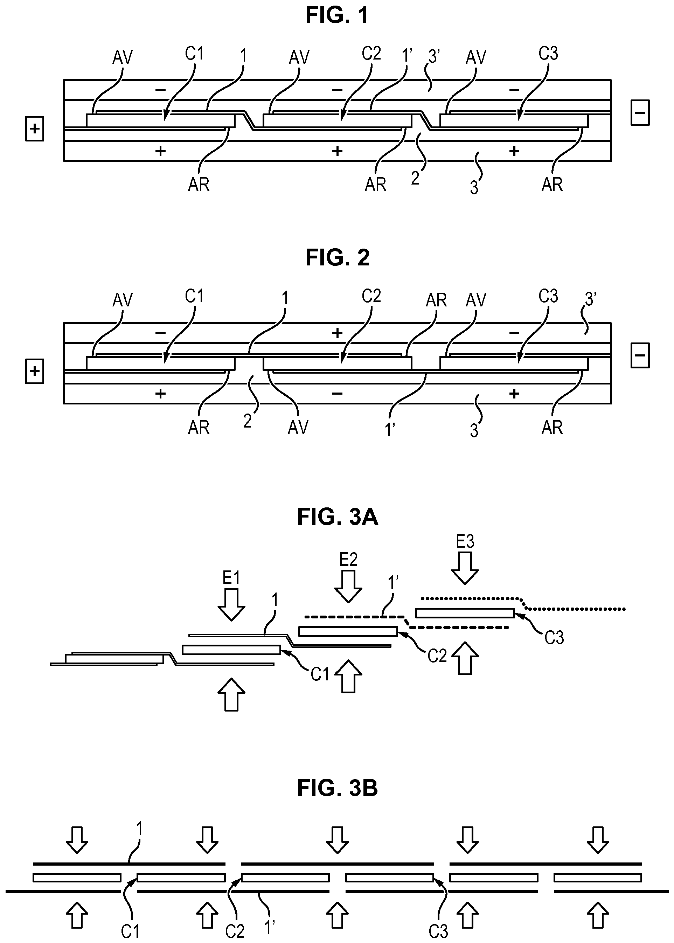

La figure 1 illustre ce mode d'interconnexion, dit « standard », sur une vue partielle en coupe d'un module comprenant des cellules C1, C2, C3.

La face avant des cellules est désignée par le repère AV, la face arrière est désignée par le repère AR.

Pour relier la face avant de la cellule C1 à la face arrière de la cellule C2, le ruban de cuivre 1 n'est pas plan mais traverse le module de la face avant vers la face arrière.

Une fois que les différentes cellules sont connectées au moyen des rubans 1, 1', etc. elles sont encapsulées dans un matériau encapsulant 2 et laminées entre deux plaques de verre 3, 3', ou entre une plaque de verre en face avant et une plaque en polymère en face arrière (ledit polymère pouvant être transparent ou non selon que le module est monofacial ou bifacial).

La traversée du ruban de la face avant vers la face arrière nécessite une déformation du ruban qui est susceptible de créer des contraintes mécaniques dans le ruban, favorisant la corrosion chimique ou bien la fatigue mécanique dudit ruban et causant ainsi des défaillances électriques (rupture des interconnexions) ou mécaniques (fissuration) dudit module.

Ce mode d'interconnexion s'applique tant aux cellules monofaciales (c'est-à-dire dont une seule des faces principales est photoactive) qu'aux cellules bifaciales (dont les deux faces principales sont photoactives). De telles cellules bifaciales peuvent être obtenues en ne métallisant que localement la face arrière d'une cellule conventionnelle, par exemple sous forme d'une grille ou sous toute autre forme.

Dans le cas d'un module comprenant des cellules bifaciales, un autre mode d'interconnexion possible est une interconnexion dite « monolithique », schématisée sur la figure 2.

Les repères identiques à ceux de la figure 1 désignent les mêmes éléments que ceux déjà décrits en référence à cette figure.

Dans ce mode d'interconnexion, les cellules sont agencées selon la polarité + et - des connexions reliant la face avant AV d'une cellule et la face arrière AR de la cellule adjacente.

Ceci permet d'utiliser un ruban de cuivre 1, 1' plat pour relier respectivement la face avant de la cellule C1 à la face arrière de la cellule C2 adjacente, sur la face avant du module, et la face avant de la cellule C2 à la face arrière de la cellule C3 adjacente, sur la face arrière du module.

Un tel mode d'interconnexion est décrit par exemple dans le brevet DD 135 014 ou dans le document EP 2 400 560 A1.

L'interconnexion monolithique présente l'avantage de permettre de connecter simultanément toutes les cellules du module, contrairement au mode d'interconnexion standard qui comprend une pluralité d'étapes, les cellules étant connectées successivement les unes aux autres. Le procédé de fabrication du module est en outre simplifié par le fait qu'aucune déformation préalable des rubans de cuivre n'est nécessaire.

Les figures 3A et 3B illustrent de manière schématique la séquence d'interconnexion des cellules respectivement dans le cas d'une interconnexion standard et d'une interconnexion monolithique.

Dans le cas d'une interconnexion standard (figure 3A), en raison de la conformation du ruban de cuivre, une cellule ne peut être assemblée que lorsque le ruban de cuivre a été connecté à la cellule adjacente. L'assemblage nécessite donc une succession d'étapes E1, E2, E3, etc. jusqu'à ce que toutes les cellules aient été connectées.

Dans le cas d'une interconnexion monolithique (figure 3B), l'assemblage est réalisé en une seule étape, deux séries de rubans de cuivre (l'une du côté de la face avant du module, l'autre du côté de la face arrière du module) étant simultanément connectés aux faces correspondantes des cellules.

Un autre avantage de l'interconnexion monolithique est qu'elle minimise les contraintes dans les rubans de cuivre et limite donc les risques de défaillance liées auxdits rubans.

Encore un autre avantage de l'interconnexion monolithique est que l'espacement des cellules peut être minimisé. En effet, dans l'interconnexion standard, un certain espacement des cellules est nécessaire pour permettre la traversée du ruban de cuivre de la face avant vers la face arrière. Un tel espacement est largement réduit, augmentant ainsi le rendement surfacique (W/m²) du module, dans le cas d'une interconnexion monolithique.

Il est de plus connu que les cellules photovoltaïques bifaciales présentent un rendement de conversion différent entre la face avant et la face arrière. Cette différence est due d'une part aux propriétés physiques du matériau formant la cellule et d'autre part à la présence d'une métallisation plus dense du côté de la face arrière que du côté de la face avant. Cette différence peut également résulter du choix d'optimiser le rendement de l'une des deux faces au détriment de l'autre.

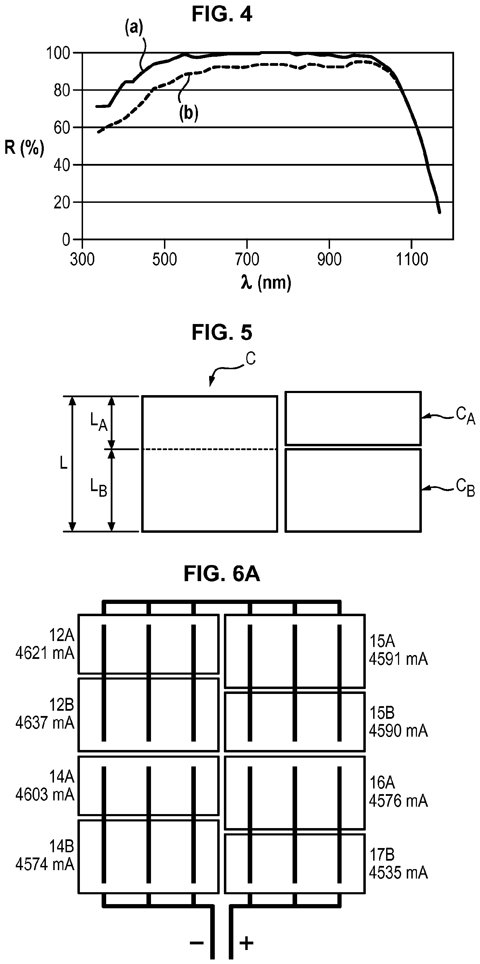

La figure 4 illustre à titre d'exemple le rendement de conversion R (« Internai Quantum Efficiency » selon la terminologie anglo-saxonne) de la face avant (courbe a) et de la face arrière (courbe b) d'une cellule bifaciale en fonction de la longueur d'onde À.

Généralement, sur les cellules bifaciales actuellement présentes sur le marché, le ratio entre le rendement de conversion entre la face avant et la face arrière est de l'ordre de 70% à 95%.

Dans un module photovoltaïque comprenant une pluralité de cellules, le courant électrique généré dépend de la cellule qui produit le moins de courant.

Par conséquent, dans un arrangement monolithique tel que décrit plus haut, le courant électrique produit par le module n'est que de 70 à 95% du courant qui aurait été produit par le module si celui-ci avait été assemblé selon le mode d'interconnexion standard.

### BREVE DESCRIPTION DE L'INVENTION

Un but de l'invention est donc de concevoir un module photovoltaïque qui puisse être assemblé de manière monolithique et dont la génération de courant électrique soit maximale.

Conformément à l'invention, il est proposé un procédé de fabrication d'un module photovoltaïque présentant une face avant destinée à être exposée au rayonnement solaire, ledit procédé comprenant au moins les étapes suivantes :
- la fourniture d'une pluralité de cellules photovoltaïques bifaciales présentant chacune un ratio de courant de court-circuit, défini, pour chaque cellule, comme étant le rapport entre :
   - le courant de court-circuit généré lorsque la face arrière de ladite cellule photovoltaïque bifaciale est éclairée et
   - le courant de court-circuit généré lorsque la face avant de ladite cellule est éclairée,
- la découpe asymétrique de chaque cellule en une première et une deuxième portion, de telle sorte que le rapport entre les superficies desdites portions soit sensiblement égal au ratio (B) de courant de court-circuit de ladite cellule ou au ratio moyen de court-circuit de l'ensemble des cellules,
- la juxtaposition desdites portions de cellules dans un plan principal du module pour former des paires de portions de cellules choisies de telle sorte que la face avant de la première portion présente un courant de court-circuit sensiblement égal au courant de court-circuit de la face arrière de la deuxième portion, lesdites portions étant agencées de sorte que la face avant de la première portion et la face arrière de la deuxième portion coïncident avec la face avant du module,
- la création d'une connexion électrique de la face avant de la première portion avec la face arrière de la deuxième portion.

Le ratio de courant de court-circuit desdites cellules est typiquement strictement inférieur à 1.

Par « courant sensiblement égal au courant de court-circuit », on entend un courant compris dans une gamme de ± 2% par rapport au courant de court-circuit, de préférence dans une gamme de ± 1% par rapport à ce courant et de manière encore préférée dans une gamme sensiblement nulle autour de ce courant.

Selon un mode de réalisation, le ratio de courant de court-circuit selon lequel on découpe chaque cellule est le ratio de courant de court-circuit propre à ladite cellule.

De manière alternative, le ratio de courant de court-circuit selon lequel on découpe chaque cellule est le ratio moyen de courant de court-circuit de l'ensemble des cellules.

Selon une forme d'exécution de l'invention, l'étape de découpe asymétrique est suivie d'une étape de découpe symétrique de chacune des première et deuxième portions, dans le sens de la largeur ou dans le sens de la longueur desdites portions.

La connexion électrique entre deux portions de cellules est typiquement réalisée par un ruban d'un matériau électriquement conducteur.

De manière particulièrement avantageuse, ledit ruban s'étend dans un plan.

Le procédé comprend en outre :
- la juxtaposition des portions de toutes les cellules dans un plan principal du module,
- la création simultanée de connexions électriques entre les portions d'une même cellule et entre les portions de cellules adjacentes.

Un autre objet concerne un module photovoltaïque susceptible d'être obtenu par un tel procédé.

Ledit module présente une face avant destinée à être exposée au rayonnement solaire et comprend une pluralité de portions de cellules photovoltaïques bifaciales asymétriques de superficies différentes juxtaposées par paires, dans lequel chaque portion de cellule comprend une face avant présentant un courant de court-circuit déterminé, et une face arrière présentant un courant de court-circuit inférieur à celui de la face avant, et dans lequel, pour chaque paire :
- la face avant de la première portion et la face arrière de la deuxième portion coïncident avec la face avant du module,
- la face avant de la première portion est connectée électriquement avec la face arrière de la deuxième portion, et la face avant de la deuxième portion est connectée électriquement avec la face arrière de la première portion d'une paire adjacente,
- le courant de court-circuit de la face avant de la première portion est sensiblement égal au courant de court-circuit de la face arrière de la deuxième portion.

La connexion électrique entre deux portions de cellules est réalisée par un ruban d'un matériau électriquement conducteur.

De manière particulièrement avantageuse, ledit ruban s'étend dans un plan.

### BREVE DESCRIPTION DES DESSINS

D'autres caractéristiques et avantages de l'invention ressortiront de la description détaillée qui va suivre, en référence aux dessins annexés sur lesquels :
- la figure 1 est une vue en coupe d'une partie d'un module assemblé selon un mode d'interconnexion standard,
- la figure 2 est une vue en coupe d'une partie d'un module assemblé selon un mode d'interconnexion monolithique,
- les figures 3A et 3B illustrent schématiquement respectivement les étapes du procédé d'interconnexion standard et du procédé d'interconnexion monolithique,
- la figure 4 illustre le rendement de la face avant (courbe a) et de la face arrière (courbe b) d'une cellule photovoltaïque bifaciale,
- la figure 5 illustre le principe de découpage d'une cellule tenant compte du ratio de courant de court-circuit conformément à l'invention,
- la figure 6A illustre un exemple d'assemblage des portions de cellules en module selon l'invention, la vue présentée étant celle de la face avant dudit module,
- la figure 6B illustre un exemple d'assemblage de portions de cellules symétriques en module, ne relevant pas de la présente invention,
- la figure 7 est un graphique présentant le gain en puissance maximale (Pmax) et en courant de court-circuit (Isc) en fonction de l'éclairement pour un module photovoltaïque selon l'invention,
- les figures 8A et 8B illustrent des variantes de découpage d'une cellule bifaciale tenant compte du ratio de courant de court-circuit selon l'invention,
- les figures 9A et 9B illustrent respectivement le découpage de chaque cellule bifaciale selon le ratio de courant de court-circuit qui lui est propre et l'assemblage des portions desdites cellules,
- les figures 10A à 10C présentent schématiquement les principes de connexion des cellules bifaciales respectivement avec la connectique standard, avec la connectique monolithique avec des cellules bifaciales de superficies identiques et avec des cellules bifaciales asymétriques selon l'invention.

### DESCRIPTION DETAILLEE DE L'INVENTION

Le procédé de fabrication d'un module photovoltaïque comprend les étapes successives décrites ci-après.

Le module photovoltaïque est destiné à être réalisé par assemblage monolithique d'une pluralité de cellules bifaciales. Ledit module photovoltaïque présente une face avant et une face arrière.

Dans un premier temps, à partir d'un lot de cellules bifaciales destinées à former le module, on détermine le courant de court-circuit (noté Isc, exprimé en mA) pour chacune des faces de la cellule. Par convention, la face avant (FAV) de la cellule est la face de la cellule pour laquelle le courant de court-circuit Isc est le plus grand et la face arrière (FAR) de la cellule est celle pour laquelle le courant de court-circuit est le plus petit des deux mesurés. On déduit de ces mesures le ratio B de courant de court-circuit entre la face arrière et la face avant.

A titre d'exemple, le tableau 1 ci-dessous illustre les propriétés de la face avant et de la face arrière d'un lot de neuf cellules.

La grandeur Voc désigne la tension du circuit ouvert (en V), Pmax est la puissance maximale fournie et FF est le facteur de forme.

La dernière colonne du tableau 1 indique le ratio B entre le courant de court-circuit de la face arrière et le courant de court-circuit de la face avant.

**Tableau 1 :**

| Cellule | FAV | | | | FAR | | | | Ratio Isc FAR/FAV |
|---|---|---|---|---|---|---|---|---|---|
| | Isc | Pmax | Voc | FF% | Isc | Pmax | Voc | FF% | |
| 12 | 9486 | 4793 | 647 | 78,085 | 8536 | 4307,7 | 634,7 | 78,39 | 89,98% |
| 14 | 9420 | 4733,9 | 646,2 | 77,76 | 8497 | 4291,7 | 643,4 | 78,50 | 90,20% |
| 15 | 9398 | 4753,1 | 646,7 | 78,20 | 8493 | 4286,6 | 643,7 | 78,90 | 90,37% |
| 16 | 9397 | 4758,4 | 645,5 | 78,44 | 8428 | 4283,0 | 642,5 | 79,10 | 89,69% |
| 17 | 9365 | 4747,8 | 645,7 | 78,55 | 8349 | 4236,5 | 642,3 | 79,0 | 89,15% |
| 18 | 9427 | 4810,8 | 644,8 | 79,14 | 8373 | 4248,5 | 640,7 | 79,3 | 88,82% |
| 19 | 9450 | 4757,4 | 646,5 | 77,87 | 8429 | 4251,5 | 643,2 | 78,4 | 89,19% |
| 20 | 9429 | 4762,4 | 645,7 | 78,2 | 8443 | 4264,8 | 642,9 | 78,6 | 89,54% |
| 22 | 9455 | 4736,0 | 646,0 | 77,5 | 8378 | 4239,7 | 642,8 | 78,7 | 88,61% |

Pour ce lot de cellules, la moyenne arithmétique des ratios des courants de court-circuit entre la face arrière et la face avant - ou ratio moyen d'Isc - est égale à 89,50%.

Selon un mode de réalisation, on découpe ensuite chaque cellule en deux portions de façon asymétrique en respectant ce ratio moyen d'Isc, c'est-à-dire en faisant en sorte que le rapport des superficies des deux portions de chaque cellule soit égal au ratio B.

Par exemple, comme illustré sur la figure 5, chaque cellule C présente une forme rectangulaire de longueur L.

On découpe chaque cellule C dans le sens de la largeur, en deux portions C_{A}, C_{B} de longueurs respectives L_{A} et L_{B}, le rapport L_{A}/L_{B} étant égal au ratio moyen des courants de court-circuit, soit 89,44%, et la somme L_{A} + L_{B} étant égale à la longueur L de la cellule. Les deux portions de cellule C_{A}, C_{B} ne sont donc pas symétriques par rapport à la ligne de coupe indiquée en pointillés.

En référence à la figure 6A, on assemble ensuite les portions de cellules découpées selon le principe exposé ci-dessus pour former le module. Dans l'exemple représenté sur la figure 6A, ce sont les cellules 12, 14, 15, 16 et 17 du tableau 1 qui ont été assemblées pour former le module.

A cet effet, on fait en sorte que les portions issues d'une même cellule soient adjacentes, la portion présentant la superficie la plus faible (désignée par le numéro de la cellule dont elle est issue suivi de la lettre A) étant orientée de telle sorte que sa face avant coïncide avec la face avant du module, tandis que la portion présentant la superficie la plus grande (désignée par le numéro de la cellule dont elle est issue suivi de la lettre B) est orientée de telle sorte que sa face arrière coïncide avec la face avant du module.

On réalise une connexion électrique d'une part entre les portions de la cellule et d'autre part entre cellules. Par exemple, comme illustré sur la figure 6A, on connecte, du côté de la face avant du module (qui est la face visible sur cette figure), deux portions d'une même cellule au moyen de trois rubans électriquement conducteurs parallèles, et l'on connecte, du côté de la face arrière du module, deux portions de deux cellules adjacentes, au moyen de trois rubans électriquement conducteurs parallèles.

Chacun desdits rubans s'étend donc soit dans le plan de la face avant, soit dans le plan de la face arrière du module. Il s'agit donc d'un assemblage monolithique.

Un avantage d'un tel assemblage est qu'il permet de connecter simultanément les différentes portions de cellules bifaciales, ce qui rend le procédé d'assemblage plus simple et plus rapide. En outre, en évitant la traversée des rubans conducteurs entre la face avant et la face arrière du module, cette construction est également plus robuste et limite les défaillances dues aux rubans conducteurs.

Naturellement, on pourra modifier le nombre et les dimensions desdits rubans sans pour autant sortir du cadre de la présente invention.

Ensuite, on finalise la fabrication du module en prenant en sandwich les portions de cellules ainsi connectées entre deux feuilles en matériau encapsulant et en laminant l'ensemble entre deux plaques formant les faces avant et arrière du module. Les plaques avant et arrière peuvent être en verre et/ou en polymère. Cette dernière étape est connue en elle-même et ne nécessite donc pas de description détaillée.

Dans un tel module, le fait que le courant de court-circuit de la cellule soit plus important en face avant est compensé par le fait que la superficie de la portion de cellule dont la face avant est exposée (portion 12A par exemple) est plus faible, tandis que le fait que le courant de court-circuit soit plus faible en face arrière est compensé par le fait que la superficie de la portion de cellule dont la face arrière est exposée (portion 12B par exemple) est plus grande.

De préférence, le module ainsi formé est un module monofacial plutôt que bifacial. En effet, le découpage et l'agencement des portions de cellules améliore la performance électrique du module en face avant mais tend à la dégrader en face arrière.

Ainsi, si l'on s'intéresse uniquement à la face avant du module, le courant de court-circuit est sensiblement égal d'une portion à l'autre pour une même cellule.

Ceci est illustré sur le tableau 2 ci-dessous, qui présente le courant de court-circuit pour la face avant et la face arrière de chaque portion de cellule.

**Tableau 2 :**

| Portion de cellule | FAV | FAR |
|---|---|---|
| | Isc | Isc |
| 12A | **4621** | 4159 |
| 12B | 5206 | **4637** |
| 14A | **4603** | 4151 |
| 14B | 5178 | **4674** |
| 15A | **4591** | 4120 |
| 15B | 5148 | **4590** |
| 16A | **4576** | 4097 |
| 17B | 5108 | **4535** |

On notera qu'au sein du lot de cellules présenté plus haut, l'inventeur a choisi d'apparier la face avant 16A de la cellule 16 avec la face arrière 17B de la cellule 17, afin d'obtenir des courants de court-circuit proches. Dans ce cas particuliers, les valeurs des courants de court-circuit des portions 16B et 17A des cellules 16 et 17 n'étaient pas satisfaisantes et ces deux portions de cellules ont donc été écartées.

Plus généralement, on relèvera qu'il n'est pas nécessaire d'apparier des portions provenant d'une même cellule pour mettre en oeuvre l'invention. Il est en effet tout à fait possible de former des paires de portions de cellules en se basant uniquement sur les valeurs d'Isc des faces avant et arrière desdites portions et en associant les portions présentant les valeurs d'Isc les plus proches l'une de l'autre.

Pour cet ensemble de portions de cellules découpées de manière asymétrique, le courant de court-circuit minimum est de 4576 mA pour les portions dont la face avant est exposée et de 4535 mA pour les portions dont la face arrière est exposée. Ces deux minima étant sensiblement égaux, cela signifie que la performance du module ne sera pas significativement affectée par des différences de courant de court-circuit entre portions de cellules.

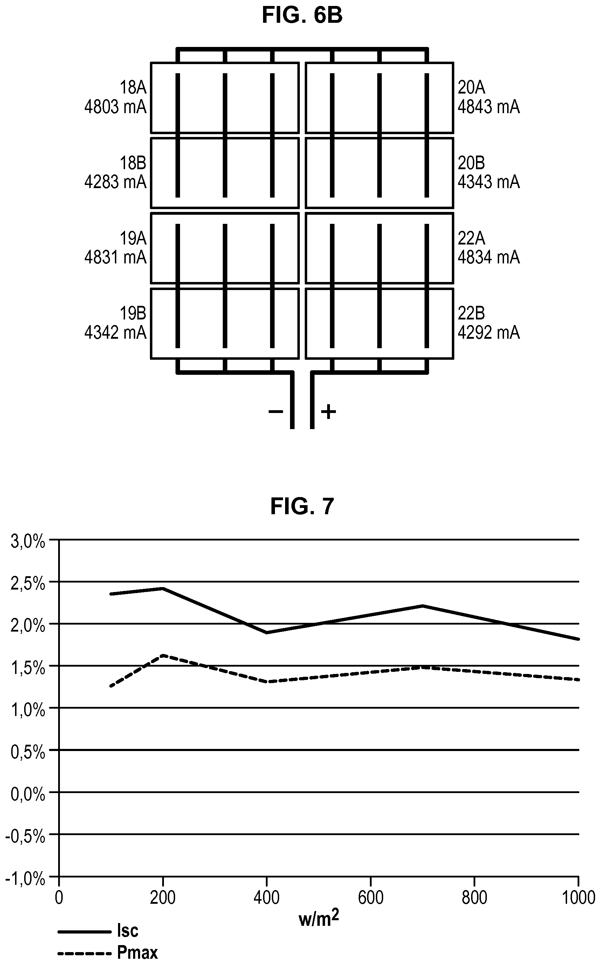

A titre de comparaison, illustrée sur la figure 6B, les cellules 18, 19, 20 et 22 ont quant à elles été découpées de manière symétrique, c'est-à-dire que les longueurs de chaque portion sont identiques. En d'autres termes, les superficies des deux portions de chaque cellule sont identiques.

Un tel mode de découpe symétrique, qui est exclu de la présente invention, est divulgué dans le document EP 1 770 791 qui porte également sur un procédé d'interconnexion monolithique. Dans ce cas, la découpe est utilisée pour faciliter la mise en module des cellules. En effet, on découpe des cellules hexagonales en quatre portions identiques et on agence lesdites parties le long de leur face oblique respective de sorte à former des rectangles. On réalise ensuite l'interconnexion des portions de cellules ainsi agencées.

Pour former le module, chaque portion de cellule désignée par la lettre A est orientée avec sa face avant coïncidant avec la face avant du module et chaque portion de cellule désignée par la lettre B est orientée avec sa face arrière coïncidant avec la face avant du module.

Le tableau 3 ci-dessous présente le courant de court-circuit pour la face avant et la face arrière de chaque portion de cellule.

**Tableau 3 :**

| Portion de cellule | FAV | FAR |
|---|---|---|
| | Isc | Isc |
| 18A | **4803** | 4310 |
| 18B | 4808 | **4283** |
| 19A | **4831** | 4312 |
| 19B | 4864 | **4342** |
| 20A | **4843** | 4329 |
| 20B | 4838 | **4343** |
| 22A | **4834** | 4292 |
| 22B | 4859 | **4292** |

Pour chaque cellule, on observe donc une différence significative entre le courant de court-circuit de la face avant d'une portion et le courant de court-circuit de la face arrière de l'autre portion (cette dernière étant orientée du côté de la face avant du module).

En effet, dans cet exemple, le courant de court-circuit minimum est de 4804 mA pour les portions dont la face avant est exposée et de 4284 mA pour les portions dont la face arrière est exposée, soit une différence de plus de 500 mA. Cela signifie que, même si les portions dont la face avant est exposée présentent un courant de court-circuit élevé, la performance du module sera conditionnée par la portion dont la face arrière est exposée et qui présente le courant de court-circuit le plus faible.

La figure 7 illustre le gain en courant de court-circuit (Isc) et en puissance maximale (Pmax) pour le module illustré à la figure 6A.

On observe un gain en Pmax de l'ordre de +1,5% pour ce module.

Le mode de réalisation décrit ci-dessus prévoit un découpage de chaque cellule en deux portions dans le sens de la largeur.

Il est cependant possible de prévoir d'autres modes de découpage des cellules (en termes de nombre de portions et/ou de sens de découpage des portions) sans pour autant sortir du cadre de la présente invention. En règle générale, le nombre de portions de cellules est pair, ce qui permet d'apparier la face avant d'une portion et la face arrière d'une autre portion de la même cellule ou d'une autre cellule, tout en conservant sensiblement la même superficie totale pour l'ensemble des paires de portions de cellules.

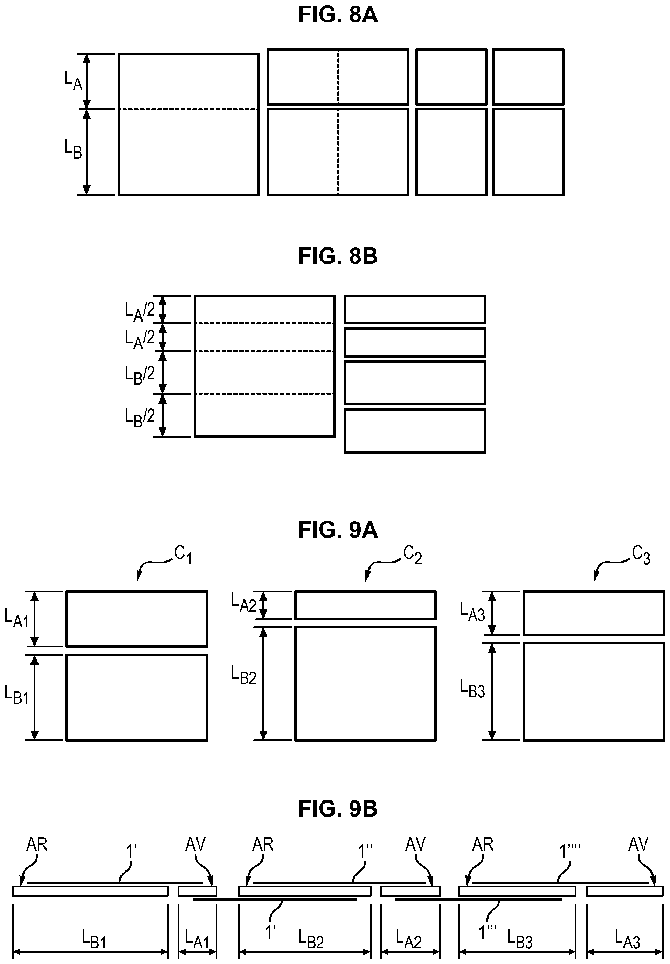

Ainsi, la figure 8A illustre une variante d'exécution dans laquelle une cellule (illustrée dans la partie gauche de la figure) est successivement découpée en deux portions dans le sens de sa largeur de manière asymétrique (c'est-à-dire en respectant le ratio L_{A}/L_{B} = B comme enseigné plus haut) puis dans le sens de sa longueur de manière symétrique (partie centrale de la figure 8A). Comme illustré dans la partie droite de la figure 8A, on obtient ainsi quatre portions de cellule.

La figure 8B illustre une autre variante d'exécution dans laquelle une cellule (illustrée dans la partie gauche de la figure) est découpée en deux portions dans le sens de sa largeur de manière asymétrique (c'est-à-dire en respectant le ratio L_{A}/L_{B} = B comme enseigné plus haut), puis chaque portion est à nouveau découpée en deux dans le même sens, de manière symétrique. Comme illustré dans la partie droite de la figure 8B, on obtient ainsi quatre portions de cellule, deux présentant une longueur L_{A}/2 et deux présentant une longueur L_{B}/2.

Dans les deux modes de réalisation décrits ci-dessus, une première opération de découpe asymétrique est réalisée en fonction des ratios B, puis elle est suivie d'une opération de découpe symétrique, soit dans la longueur, soit dans la largeur. Ces modes de réalisation permettent de diminuer le courant de chaque « string » de portions de cellules et donc de limiter les pertes de courant par effet Joule. On rappelle qu'un string de cellules correspond classiquement à une unité de cellules connectées en série. Dans un module standard, un string comporte environ dix cellules et les strings sont interconnectés entre eux.

Par ailleurs, l'invention n'impose pas que les cellules soient découpées de façon asymétrique en respectant le même ratio B pour toutes les cellules, correspondant au ratio moyen de l'ensemble des cellules.

Selon un mode de réalisation de l'invention, on détermine le ratio B pour chaque cellule et l'on découpe ladite cellule en respectant le ratio B respectif.

Comme illustré sur la figure 9A, on considère trois cellules C1, C2, C3 présentant des ratios de courant de court-circuit différents. On découpe donc la cellule C1 en deux portions dans le sens de la largeur, en faisant en sorte que le ratio L_{A1}/L_{B1} soit égal au ratio B pour cette cellule ; on découpe la cellule C2 en deux portions dans le sens de la largeur, en faisant en sorte que le ratio L_{A2}/L_{B2} soit égal au ratio B pour cette cellule ; enfin, on découpe la cellule C3 en deux portions dans le sens de la largeur, en faisant en sorte que le ratio L_{A3}/L_{B3} soit égal au ratio B pour cette cellule.

La figure 9B illustre la connexion des portions desdites cellules pour former un module.

Les portions L_{A1}, L_{A2} et L_{A3} présentant la superficie la plus faible sont agencées de sorte que leur face avant coïncide avec la face avant du module, tandis que les portions L_{B1}, L_{B2} et L_{B3} présentant la superficie la plus grande sont agencées de sorte que leur face arrière coïncide avec la face avant du module.

Une connexion électrique 1, 1", 1'''' est réalisée entre les portions de chaque paire (L_{A1}, L_{B1}), (L_{A2}, L_{B2}) et (L_{A3}, L_{B3}) au niveau de la face avant du module et une connexion électrique 1', 1'" est réalisée entre des portions adjacentes de deux paires différentes au niveau de la face arrière du module. Chacune de ces connexions est réalisée par un ruban plan d'un matériau électriquement conducteur.

Ce mode de réalisation présente l'avantage d'optimiser la découpe de chaque cellule, puisque le ratio de découpage dépend spécifiquement du ratio B de ladite cellule.

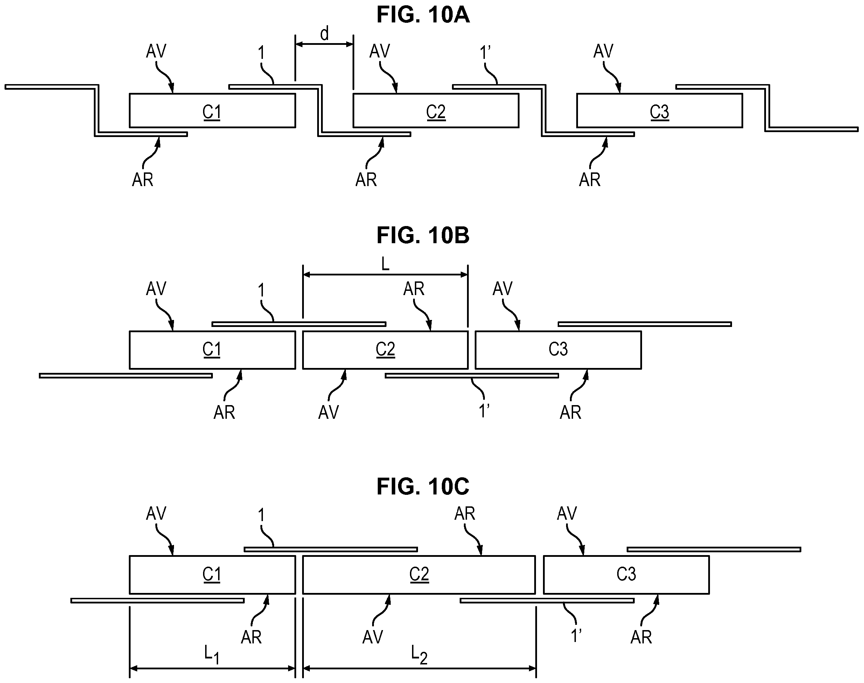

Les figures 10A à 10C illustrent les avantages de la connectique monolithique avec des cellules bifaciales selon l'invention (illustrée sur la figure 10C), par rapport à la connectique standard avec des cellules bifaciales (illustrée sur la figure 10A) et par rapport à la connectique monolithique avec des cellules bifaciales de superficies identiques (illustrée sur la figure 10B).

En référence à la figure 10A, des cellules bifaciales C1, C2, C3 sont agencées successivement, les faces avant AV de chacune de ces cellules étant coplanaires et formant la face avant du module. Les faces arrière AR de chacune de ces cellules sont coplanaires et forment la face arrière du module.

La face avant d'une cellule est connectée électriquement à la face arrière de la cellule adjacente au moyen d'un ruban électriquement conducteur 1, 1'.

Pour faciliter le passage dudit ruban conducteur de la face avant d'une cellule à la face arrière de la cellule adjacente, une distance d suffisamment importante est ménagée entre deux cellules adjacentes. Par exemple, la distance d est typiquement de l'ordre de 2 à 4 mm.

En référence à la figure 10B, des cellules bifaciales C1, C2, C3 présentant chacune une longueur identique L, sont agencées successivement, la face avant AV de la cellule C1 étant coplanaire avec la face arrière AR de la cellule C2 adjacente du côté de la face avant du module et une connexion électrique étant assurée entre ces deux faces coplanaires au moyen d'un ruban électriquement conducteur 1. La face avant AV de la cellule C2 est coplanaire avec la face arrière AV de la cellule C3 adjacente, du côté de la face arrière du module, et une connexion électrique étant assurée entre ces deux faces coplanaires au moyen d'un ruban électriquement conducteur 1'. En d'autres termes, la face avant du module comprend alternativement la face avant d'une cellule et la face arrière d'une cellule adjacente.

Dans la mesure où les rubans conducteurs 1, 1' s'étendent chacun dans un plan, la distance ménagée entre deux cellules adjacentes peut être inférieure à la distance d prévue pour la connectique standard. Cette distance inter-cellules peut typiquement être de l'ordre de 1 mm.

En référence à la figure 10C, qui illustre un mode de réalisation de l'invention, des cellules bifaciales C1, C2, C3 présentant chacune une longueur identique L, sont agencées successivement par paires. Au sein de la paire C1, C2, la face avant AV de la cellule C1 est coplanaire avec la face arrière AR de la cellule C2 adjacente du côté de la face avant du module et une connexion électrique est assurée entre ces deux faces coplanaires au moyen d'un ruban électriquement conducteur 1. Comme exposé plus haut, la longueur L₁ de la cellule C1 et la longueur L₂ de la cellule C2 obéissent à la relation : L₁/L₂ = B, où B est le ratio d'Isc. La face avant AV de la cellule C2 est coplanaire avec la face arrière AV de la cellule C3 adjacente, qui appartient à une autre paire de cellules, du côté de la face arrière du module, et une connexion électrique est assurée entre ces deux faces coplanaires au moyen d'un ruban électriquement conducteur 1'.

Le rapport entre le rendement surfacique de la connectique monolithique selon l'invention (figure 10C) et le rendement surfacique de la connectique standard (figure 10A) est égal à : 2B / (1+B). Ce rapport est inférieur à 1, ce qui signifie que le rendement surfacique du module conforme à l'invention est plus faible (de l'ordre de -5% si B=90%) que celui d'un module avec une connectique standard. En revanche, le module selon l'invention bénéficie d'un procédé d'assemblage plus aisé et plus rapide, et est moins sujet à des défaillances électriques et mécaniques des rubans conducteurs. D'autre part, comme cela est présenté plus bas, le module selon l'invention autorise un espacement plus faible entre portions de cellules. Ceci qui représente un gain d'environ 1,3% pour des cellules de taille 156 mm * 156 mm. En effet, on considère un espacement standard de 4 mm pour des cellules de 156 mm. L'invention utilisant des cellules découpées (de l'ordre de 78 mm) et un espacement de 1 mm, le gain est de (156 +4) / (2*(78+1)) = 160/158 = 1,013 soit 1.3%)

Le rapport entre le rendement surfacique de la connectique monolithique selon l'invention (figure 10C) et le rendement surfacique de la connectique monolithique à cellules symétriques (figure 10B) est égal à : 2 / (1+B). Ce rapport est supérieur à 1, ce qui signifie que le rendement surfacique du module conforme à l'invention est plus élevé (de l'ordre de +5% si B=90%) que celui d'un module avec une connectique monolithique à cellules symétriques.

La perte relative ΔR (en %) du rendement surfacique liée à l'espacement des cellules est donnée par la formule : ΔR = d/L * 100%.

Avec un module monolithique, la distance d entre cellules peut être réduite à 1 mm, ce qui représente une diminution de distance de 1 à 3 mm par rapport à la distance entre cellules avec une connectique standard. Si l'on considère des cellules de longueur L = 156 mm, le gain relatif en rendement est compris entre 1/156 et 3/156 pour le module monolithique symétrique de la figure 10B, soit entre 0,6% et 2%. Pour le module monolithique asymétrique selon l'invention (figure 10C), les cellules découpées présentent une longueur d'environ 78 mm, d'où un gain maximal de 1,3% comme exposé ci-dessus.

### REFERENCES

DD 135 014
EP 1 770 791

## Revendications

1. Procédé de fabrication d'un module photovoltaïque présentant une face avant destinée à être exposée au rayonnement solaire, ledit procédé comprenant au moins les étapes suivantes :
- la fourniture d'une pluralité de cellules photovoltaïques bifaciales présentant chacune un ratio (B) de courant de court-circuit, ledit ratio (B) étant défini, pour chaque cellule, comme étant le rapport entre :
• le courant de court-circuit (Isc) généré lorsque la face arrière (AR) de ladite cellule photovoltaïque bifaciale est éclairée et
• le courant de court-circuit généré lorsque la face avant (AV) de ladite cellule est éclairée,
- la découpe asymétrique de chaque cellule en une première et une deuxième portion, de telle sorte que le rapport entre les superficies desdites portions soit sensiblement égal au ratio (B) de courant de court-circuit de ladite cellule ou au ratio moyen de court-circuit de l'ensemble des cellules,
- la juxtaposition desdites portions de cellules dans un plan principal du module pour former des paires de portions de cellules choisies de telle sorte que la face avant de la première portion présente un courant de court-circuit sensiblement égal au courant de court-circuit de la face arrière de la deuxième portion, lesdites portions étant agencées de sorte que la face avant de la première portion et la face arrière de la deuxième portion coïncident avec la face avant du module,
- la création d'une connexion électrique de la face avant de la première portion avec la face arrière de la deuxième portion.

2. Procédé selon la revendication 1, dans lequel le ratio de courant de court-circuit selon lequel on découpe chaque cellule est le ratio de courant de court-circuit propre à ladite cellule.

3. Procédé selon la revendication 1, dans lequel le ratio de courant de court-circuit selon lequel on découpe chaque cellule est le ratio moyen de courant de court-circuit de l'ensemble des cellules.

4. Procédé selon l'une des revendications 1 à 3, dans lequel l'étape de découpe asymétrique est suivie d'une étape de découpe symétrique de chacune des première et deuxième portions, dans le sens de la largeur ou dans le sens de la longueur desdites portions.

5. Procédé selon l'une des revendications 1 à 4, dans lequel la connexion électrique entre deux portions de cellules est réalisée par un ruban d'un matériau électriquement conducteur.

6. Procédé selon la revendication 5, dans lequel ledit ruban s'étend dans un plan.

7. Procédé selon l'une des revendications 5 ou 6, comprenant :
- la juxtaposition des portions de toutes les cellules dans un plan principal du module,
- la création simultanée de connexions électriques entre les portions d'une même cellule et entre les portions de cellules adjacentes.

8. Module photovoltaïque présentant une face avant destinée à être exposée au rayonnement solaire, comprenant une pluralité de portions de cellules photovoltaïques bifaciales asymétriques de superficies différentes juxtaposées par paires, dans lequel chaque portion de cellule comprend une face avant présentant un courant de court-circuit déterminé, et une face arrière présentant un courant de court-circuit inférieur à celui de la face avant, et dans lequel, pour chaque paire :
- la face avant de la première portion et la face arrière de la deuxième portion coïncident avec la face avant du module,
- la face avant de la première portion est connectée électriquement avec la face arrière de la deuxième portion, et la face avant de la deuxième portion est connectée électriquement avec la face arrière de la première portion d'une paire adjacente,
- le courant de court-circuit de la face avant de la première portion est sensiblement égal au courant de court-circuit de la face arrière de la deuxième portion.

9. Module selon la revendication 8, dans lequel la connexion électrique entre deux portions de cellules est réalisée par un ruban d'un matériau électriquement conducteur.

10. Module selon la revendication 9, dans lequel ledit ruban s'étend dans un plan.

## Patentansprüche

1. Verfahren zur Herstellung eines photovoltaischen Moduls mit einer Vorderseite, die dazu bestimmt ist, der Sonnenstrahlung ausgesetzt werden, wobei das Verfahren zumindest die folgenden Schritte umfasst:
- die Bereitstellung einer Mehrzahl von zweiseitigen photovoltaischen Zellen, die jeweils ein Verhältnis (B) des Kurzschlussstroms aufweisen, wobei das Verhältnis (B) für jede Zelle als das Verhältnis definiert ist zwischen:
• dem Kurzschlussstrom (Isc), der erzeugt wird, wenn die Rückseite (AR) der zweiseitigen photovoltaischen Zelle beleuchtet wird und
• dem Kurzschlussstrom, der erzeugt wird, wenn die Vorderseite (AV) der Zelle beleuchtet wird,
- den asymmetrischen Zuschnitt jeder Zelle in einen ersten und einen zweiten Abschnitt, so dass das Verhältnis zwischen den Oberflächen der Abschnitte im Wesentlichen gleich dem Verhältnis (B) des Kurzschlussstroms der Zelle oder dem durchschnittlichen Kurzschlussverhältnis aller Zellen ist,
- die Nebeneinanderstellung der Zellenabschnitte auf einer Hauptebene des Moduls zur Bildung von Paaren von Zellenabschnitten, die so gewählt sind, dass die Vorderseite des ersten Abschnitts einen Kurzschlussstrom aufweist, der im Wesentlichen gleich dem Kurzschlussstrom der Rückseite des zweiten Abschnitts ist, wobei die Abschnitte so angeordnet sind, dass die Vorderseite des ersten Abschnitts und die Rückseite des zweiten Abschnitts mit der Vorderseite des Moduls zusammenfallen,
- die Herstellung eines elektrischen Anschlusses zwischen der Vorderseite des ersten Abschnitts und der Rückseite des zweiten Abschnitts.

2. Verfahren nach Anspruch 1, wobei das Verhältnis des Kurzschlussstroms, nach dem jede Zelle zugeschnitten ist, das Verhältnis des der Zelle eigenen Kurzschlussstroms ist.

3. Verfahren nach Anspruch 1, wobei das Verhältnis des Kurzschlussstroms, nach dem jede Zelle zugeschnitten ist, das durchschnittliche Verhältnis des Kurzschlussstroms aller Zellen ist.

4. Verfahren nach einem der Ansprüche 1 bis 3, wobei auf den Schritt des asymmetrischen Zuschnitts ein Schritt mit symmetrischem Zuschnitt jedes des ersten und des zweiten Abschnitts in Richtung der Breite oder in Längsrichtung der Abschnitte folgt.

5. Verfahren nach einem der Ansprüche 1 bis 4, wobei der elektrische Anschluss zwischen zwei Zellenabschnitten durch ein Band aus einem elektrisch leitenden Material hergestellt wird.

6. Verfahren nach Anspruch 5, wobei sich das Band auf einer Ebene erstreckt.

7. Verfahren nach einem der Ansprüche 5 oder 6, umfassend:
- die Nebeneinanderstellung der Abschnitte aller Zellen auf einer Hauptebene des Moduls,
- die gleichzeitige Herstellung von elektrischen Anschlüssen zwischen den Abschnitten einer gleichen Zelle und zwischen den Abschnitten von nebeneinander liegenden Zellen.

8. Photovoltaisches Modul mit einer Vorderseite, die dazu bestimmt ist, der Sonnenstrahlung ausgesetzt werden, umfassend eine Mehrzahl von zweiseitigen asymmetrischen photovoltaischen Zellenabschnitte unterschiedlicher Oberflächen, die paarweise nebeneinander gestellt sind, wobei jeder Zellenabschnitt eine Vorderseite umfasst, die einen bestimmten Kurzschlussstrom aufweist, und eine Rückseite, die einen Kurzschlussstrom aufweist, der geringer als derjenige der Vorderseite ist, und in dem bei jedem Paar:
- die Vorderseite des ersten Abschnitts und die Rückseite des zweiten Abschnitts mit der Vorderseite des Moduls zusammenfallen,
- die Vorderseite des ersten Abschnitts elektrisch an die Rückseite des zweiten Abschnitts angeschlossen ist, und die Vorderseite des zweiten Abschnitts elektrisch an die Rückseite des ersten Abschnitts eines anschließenden Paares angeschlossen ist,
- der Kurzschlussstrom der Vorderseite des ersten Abschnitts im Wesentlichen gleich dem Kurzschlussstrom der Rückseite des zweiten Abschnitts ist.

9. Modul nach Anspruch 8, wobei der elektrische Anschluss zwischen zwei Zellenabschnitten durch ein Band aus einem elektrisch leitenden Material hergestellt wird.

10. Modul nach Anspruch 9, wobei sich das Band auf einer Ebene erstreckt.

## Claims

1. Method for producing a photovoltaic module having a front face intended to be exposed to solar radiation, said method comprising at least the following steps:
- providing a plurality of bifacial photovoltaic cells each having a short-circuit current ratio (B), said ratio (B) being defined, for each cell, as being the ratio between:
• the short-circuit current (Isc) generated when the rear face (AR) of said bifacial photovoltaic cell is illuminated and
• the short-circuit current generated when the front face (AV) of said cell is illuminated,
- asymmetrically cutting each cell into a first and a second portion, such that the ratio between the surface areas of said portions is substantially equal to the short-circuit current ratio (B) of said cell or to the average short-circuit ratio of the set of cells,
- juxtaposing said cell portions in a main plane of the module to form pairs of cell portions chosen such that the front face of the first portion has a short-circuit current substantially equal to the short-circuit current of the rear face of the second portion, said portions being arranged such that the front face of the first portion and the rear face of the second portion coincide with the front face of the module,
- creating an electrical connection of the front face of the first portion with the rear face of the second portion.

2. Method according to claim 1, wherein the short-circuit current ratio according to which each cell is cut is the short-circuit current ratio specific to said cell.

3. Method according to claim 1, wherein the short-circuit current ratio according to which each cell is cut is the average short-circuit current ratio of the set of cells.

4. Method according to one of claims 1 to 3, wherein the step of asymmetrical cutting is followed by a step of symmetrical cutting of each of the first and second portions, in the sense of the width or in the sense of the length of said portions.

5. Method according to one of claims 1 to 4, wherein the electrical connection between two cell portions is made by a strip of an electrically conducting material.

6. Method according to claim 5, wherein said strip extends in a plane.

7. Method according to one of claims 5 or 6, comprising:
- juxtaposing the portions of all the cells in a main plane of the module,
- the simultaneous creation of electrical connections between the portions of a same cell and between adjacent cell portions.

8. Photovoltaic module having a front face intended to be exposed to solar radiation, comprising a plurality of asymmetrical bifacial photovoltaic cell portions of different surface areas juxtaposed by pairs, wherein each cell portion comprises a front face having a determined short-circuit current, and a rear face having a short-circuit current lower than that of the front face, and wherein, for each pair:
- the front face of the first portion and the rear face of the second portion coincide with the front face of the module,
- the front face of the first portion is electrically connected with the rear face of the second portion, and the front face of the second portion is electrically connected with the rear face of the first portion of an adjacent pair,
- the short-circuit current of the front face of the first portion is substantially equal to the short-circuit current of the rear face of the second portion.

9. Module according to claim 8, wherein the electrical connection between two cell portions is made by a strip of an electrically conducting material.

10. Module according to claim 9, wherein said strip extends in a plane.
